# EUROPEAN PATENT SPECIFICATION

(11) **EP 4 176 471 B1**
(45) Date of publication and mention of the grant of the patent: **04.12.2024**
(21) Application number: 21706914.5
(22) Date of filing: 18.02.2021
(51) Int. Cl.: H01L 31/18, H01L 21/67

(54) **METHOD FOR DEPOSITING FEATURES ON SOLAR CELL PIECES, METHOD FOR PROCESSING A SOLAR CELL, APPARATUS FOR PROCESSING SOLAR CELLS**
VERFAHREN ZUR ABSCHEIDUNG VON MERKMALEN AUF SOLARZELLENTEILEN, VERFAHREN ZUR VERARBEITUNG EINER SOLARZELLE, VORRICHTUNG ZUR VERARBEITUNG VON SOLARZELLEN
PROCÉDÉ DE DÉPÔT D'ÉLÉMENTS SUR DES PIÈCES DE CELLULE SOLAIRE, PROCÉDÉ DE TRAITEMENT D'UNE CELLULE SOLAIRE, APPAREIL DE TRAITEMENT DE CELLULES SOLAIRES

(43) Date of publication of application: 10.05.2023
(73) Proprietor: Applied Materials Italia S.R.L., 31048 San Biagio di Callalta (TV) (IT)
(72) Inventor: COLLA, Davide, 31100 Treviso (IT); GALIAZZO, Marco, 31055 Quinto di Treviso (TV) (IT); GISLON, Daniele, 30036 Santa Maria di Sala - Venice (IT); CERASTI, Lorenzo, 31048 San Biagio di Callalta (TV) (IT)
(74) Representative: Zimmermann & Partner Patentanwälte mbB
(86) International application number: PCT/EP2021/054016
(87) International publication number: WO 2022/174903

(56) References cited:
- WO-A1-2019/141363
- US-A1- 2018 190 860

## Description

### FIELD

Embodiments described herein relate to apparatuses and methods for manufacturing solar cell arrangements, more specifically shingled solar cell arrangements including a plurality of overlapping solar cell pieces. Adjacent solar cell pieces in a shingled solar cell arrangement are bonded to each other by an electrically conductive adhesive. Embodiments described herein specifically relate to methods involving a separation of solar cells into solar cell pieces and a deposition of features, such as electrically conductive adhesives, on the solar cell pieces.

### BACKGROUND

Solar cells are photovoltaic structures that convert sunlight directly into electrical power. The efficiency of the solar cells can be affected by an active area on a front surface of the solar cell which is exposed to light for converting sunlight into electrical power. The active area can be reduced due to the presence of electrical contacts, such as fingers and/or bus bars, on the front surface of the solar cells. The presence of the electrical contacts on the front surface of the solar cells can thus reduce a power of a solar cell system including the solar cells.

Shingled solar cell arrangements can increase an output power of a solar cell system. The increase in the output power can be affected by a quality of a manufacturing process, such as a quality of the units used to assemble the shingled solar cell arrangement. Further, a proper assembling of the shingled solar cell arrangement can be cumbersome, and a throughput and/or yield can be low.

US 2018/1.90860 A1 describes a cleaving system. During operation, side segments can rotate around axes. The rotation of the side segments can cleave a wafer into three strips, with each strip attached to a corresponding segment of the cleaving platform via vacuum cups. In some cases, after cleaving, the two side segments of the cleaving platform can rotate upward, back to their horizontal position while continuing to hold the wafer strips. Subsequently, the entire cleaving platform can be lowered to release the wafer strips onto a conveyor. The step of applying a conductive adhesive paste can occur before scribing or after cleaving.

In view of the above, new methods and apparatuses for processing solar cells for the manufacture of shingled solar cell arrangements that overcome at least some of the problems in the art are beneficial. The present disclosure particularly aims at improving the manufacturing process of solar cell arrangements, such as shingled solar cells.

### SUMMARY

The method and the apparatus of the invention are defined in the claims 1 and 6 respectively.

### BRIEF DESCRIPTION OF THE DRAWINGS

The accompanying drawings relate to embodiments of the disclosure and are described in the following:
- FIG. 1: shows an example of a solar cell;
- FIG. 2: shows an example of solar cell pieces obtained by cleaving the solar cell of Fig. 1;
- FIG. 3: shows an example of a solar cell piece;
- FIG. 4: shows an example of a shingled solar cell arrangement;
- FIGs. 5-7: illustrate the operation of a cleaving system as described herein;
- FIG. 8: shows a deposition of features on solar cell pieces jointly arranged in a same deposition area, wherein the solar cell pieces are obtained by cleaving a solar cell using a cleaving system shown on Figs. 5-7;
- FIGs. 9-11: illustrate the operation of a cleaving system as described herein, wherein the cleaving system is used to cleave a solar cell;
- FIGs. 12-13: illustrate the operation of a cleaving system as described herein, wherein the cleaving system is used for positioning the solar cell pieces in a target position;
- FIG. 14: shows an example of a solar cell held by holding members of a cleaving system as described herein;
- FIG. 15: shows the solar cell pieces of the solar cell shown in Fig. 14, after the solar cell pieces have been arranged in a target position by the holding members;
- FIGs. 16-17: show an apparatus for processing solar cells according to embodiments described herein;
- FIG. 18: shows an apparatus for processing solar cells according to embodiments described herein;
- FIG. 19: shows an overlapping arrangement of solar cell pieces; and
- FIGs. 20-21: show examples of cleaving systems as described herein.

### DETAILED DESCRIPTION OF EMBODIMENTS

Reference will now be made in detail to the various embodiments of the disclosure, one or more examples of which are illustrated in the figures. Within the following description of the drawings, the same reference numbers refer to same components. Generally, only the differences with respect to individual embodiments are described. Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

A solar cell or solar cell piece, as described herein, may include a conductive structure or a conductive pattern, particularly a conductive line pattern. A conductive pattern or structure can include one or more bus bars and/or a plurality of fingers. The solar cell or solar cell piece can include a conductive pattern or structure on the front side of the solar cell or solar cell piece. Additionally or alternatively, a solar cell or solar cell piece can include a conductive pattern or structure on the back side of the solar cell or solar cell piece. For example, a solar cell or solar cell piece can include a first conductive pattern including one or more bus bars and a plurality of fingers on the front side of the solar cell or solar cell piece. The solar cell or solar cell piece can include a second conductive pattern including one or more bus bars on the back side of the solar cell or solar cell piece.

Embodiments described herein relate to shingled solar cell arrangements. A shingled solar cell arrangement can be made of a plurality of overlapping solar cell pieces. Adjacent solar cell pieces are electrically connected to each other in the overlapping region, e.g. via adhesives as described herein. The solar cell pieces are connected in series such that a current generated by the individual solar cell pieces flows along the series of solar cell pieces to be collected, for example, at an end portion of the solar cell arrangement. The overlapping configuration can provide high-efficiency solar cell arrangements. In particular, the solar cell arrangements allow for increasing the power of a solar cell system by increasing a used or active area. Typically, the overlapping configuration can increase the power by, for example, 20 to 40 Watts. The used or active area can correspond to an area that is irradiated by solar light and that participates in the generation of power. For example, the used or active area can correspond to an area of the solar cells that is not covered by, for example, conductive line patterns, such as fingers and/or bus bars.

According to an embodiment, a method for processing a solar cell is provided. The method includes the following operations, which may be performed in the order provided. A solar cell is held by a plurality of holding members of a cleaving system. The plurality of holding members include a first holding member and a second holding member. The first holding member is rotatable about a first rotation axis. The first rotation axis and the solar cell held by the plurality of holding members are disposed in a substantially same plane. At least a first rotation movement of the first holding member about the first rotation axis is performed to separate the solar cell into a plurality of solar cell pieces including a first solar cell piece and a second solar cell piece. At least a second rotation movement of the first holding member in a sense opposite to the first rotation movement is performed to arrange the first solar cell piece in a target position. One or more first features are deposited on the first solar cell piece and one or more second features are deposited on the second solar cell piece while the first solar cell piece and the second solar cell piece are disposed in a same deposition area.

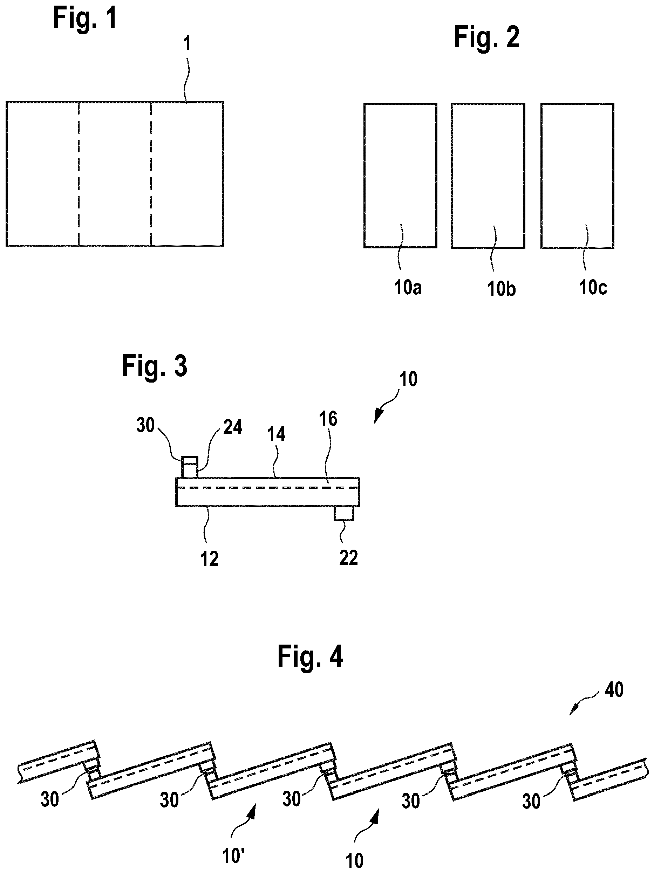

Fig. 1 shows an example of a solar cell 1. The dashed lines in Fig. 1 indicate locations where the solar cell 1 may be cleaved. The cleaving may be performed using a cleaving system as described herein. The terminology "cleaving a solar cell" can be understood as "separating a solar cell into solar cell pieces". The cleaving of the solar cell 1 along the dashed lines separates the solar cell 1 into a plurality of solar cell pieces or shingles, for example three solar cell pieces 10a, 10b and 10c as shown in Fig. 2. For example, a solar cell may be cleaved into two or more, three or more, four or more, five or more, or six or more solar cell pieces.

A solar cell or solar cell piece can be made of a semiconductor material, for example Si. A solar cell piece or solar cell shingle, as described herein, can be understood as a piece or segment of a solar cell obtained by cleaving the solar cell i.e. separating the solar cell into smaller pieces. A solar cell piece is smaller than the solar cell from which the solar cell piece originates. A solar cell piece may be a strip of material having an elongated shape, e.g. a rectangular shape. A solar cell, as described herein, can be understood as a full solar cell, i.e. a solar cell that has not been separated into solar cell pieces. A solar cell can have a square or rectangular shape, such as the solar cell shown in Fig. 1, or another shape, such as a pseudo-square shape i.e. a square with rounded or chamfered edges.

Prior to being cleaved, a solar cell may be scribed, e.g. using a laser. Scribing the solar cell can include removing a portion of material from the solar cell along a predetermined line i.e. a scribing line. For example, one or more grooves may be formed in the solar cell by laser scribing. For example, before the solar cell 1 shown in Fig. 1 is cleaved, the solar cell 1 may be scribed along the dashed lines shown in Fig. 1. Grooves may be formed along the dashed lines. The scribed portions of a solar cell can provide breaking lines along which the solar cell may be cleaved. Scribing the solar cell can facilitate a subsequent cleaving of the solar cell.

Fig. 3 shows an example of a solar cell piece 10. The solar cell piece 10 has a back side 12 and a front side 14 opposite the back side 12. The solar cell piece 10 includes a photovoltaic area 16 at the front side 14 of the solar cell piece 10. The photovoltaic area 16 is configured for receiving electromagnetic radiation, particularly sunlight, which may be converted into electrical power by the solar cell piece 10. A solar cell piece 10 may include a bus bar 24. The bus bar 24 may be provided on the front side 24 of the solar cell piece 10. The solar cell piece 10 may include a bus bar 22. The bus bar 22 may be provided on the back side 12 of the solar cell piece 10. A solar cell piece 10 may include an adhesive 30. The adhesive 30 may be provided on the front side 14 of the solar cell piece 10. The adhesive 30 may be provided on the bus bar 24. In other examples, the adhesive 30 may be provided on the back side 12 of the solar cell piece 10, such as on the busbar 22.

Fig. 4 shows a solar cell arrangement 40, in particular a shingled solar cell arrangement. The shingled solar cell arrangement can be manufactured according to embodiments of the methods described herein. The solar cell arrangement 40 includes a plurality of solar cell pieces. The solar cell pieces are arranged in a manner such that adjacent solar cell pieces of the solar cell arrangement 40 overlap with each other. As shown for example in Fig. 4, in a solar cell arrangement 40, a solar cell piece 10 may be connected, i.e. attached, to an adjacent solar cell piece 10'. The solar cell piece 10 may be connected to the adjacent solar cell piece 10' by an adhesive 30. The adhesive 30 may be arranged in an overlapping region of the solar cell piece 10 and the solar cell piece 10'. The adhesive 30 may connect a bus bar on the back side of the solar cell piece 10 to a bus bar on the front side of the solar cell piece 10'.

An adhesive as described herein (for example the first adhesive, second adhesive or third adhesive as described herein) is configured for connecting, particularly attaching, solar cell pieces to each other. An adhesive can be an electrically conductive adhesive (ECA). An adhesive can be selected from the group consisting of solder, silver paste, silicone-based electrically conductive adhesive, and epoxy-based electrically conductive adhesive. An adhesive can be deposited, such as printed, on a solar cell piece. During printing, the adhesive can be in a substantially liquid form. An adhesive can provide for an electrical and mechanical connection between solar cell pieces in a shingled solar cell arrangement.

Embodiments described herein relate to methods for depositing adhesives, or more generally features, on solar cell pieces before a solar cell arrangement 40 is formed i.e. before the solar cell pieces are assembled in an overlapping configuration. A solar cell is cleaved into multiple solar cell pieces using a cleaving system. Thereafter, the solar cell pieces (or at least one solar cell piece) of the solar cell are arranged in a target position. That is, the solar cell pieces of the solar cell are positioned relative to each other to provide an arrangement of the solar cell pieces which is suitable for a subsequent deposition of features on the solar cell pieces in question. Thereafter, the solar cell pieces of the solar cell can be jointly transported from the cleaving system to the deposition area by a gripper adapted for gripping and moving multiple solar cell pieces together. While the solar cell pieces are jointly disposed in the same deposition area, the deposition station can deposit respective features, e.g. respective adhesives, on the solar cell pieces. Particularly, the features can be deposited in parallel on the solar cell pieces that are disposed in the deposition area.

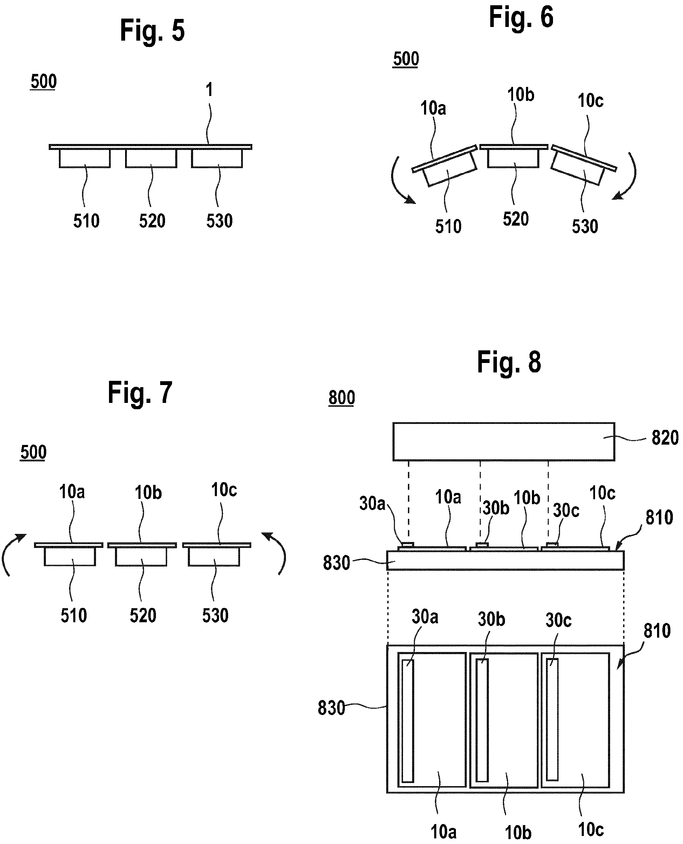

Fig. 5 shows a side view of a cleaving system 500 including a plurality of holding members. The exemplary cleaving system 500 shown in Fig. 5 includes a holding member 510, a holding member 520, and a holding member 530 i.e. three holding members. The holding members may be elongated members which may be arranged next to each other. A solar cell 1 may be supported by the holding members. For example, each holding member can hold a portion of the solar cell 1 in a fixed position by applying a suction force to the solar cell 1.

One or more holding members can be movable, particularly rotatable around a rotation axis perpendicular to the drawing plane of Fig. 5. By a first rotation movement, or cleaving movement, of one or more holding members, the solar cell 1 can be separated into solar cell pieces. In the example illustrated in Fig. 6, the solar cell 1 is separated into a solar cell piece 10a, a solar cell piece 10b, and a solar cell piece 10c by a rotation of the holding member 510 and a rotation of the holding member 530. The holding member 520 may be stationary i.e. may not be moved during the cleaving process. Fig. 6 shows the holding members in a configuration after holding member 510 and holding member 530 have performed the first rotation movement to cleave the solar cell 1. Each holding member 510, 520 and 530 holds a respective solar cell piece 10a, 10b and 10c of the solar cell 1, e.g. by applying a suction force to the solar cell piece in question.

After the first rotation movement to cleave the solar cell 1, the holding member 510 and the holding member 530 are rotated back into, or at least towards, their initial position i.e. a second rotation movement in a sense opposite to the first rotation movement. Fig. 7 shows the holding members after such a second rotation movement, or rejoining movement, has been performed. After the second rotation movement, the solar cell pieces 10a, 10b and 10c can be in a target position as shown in Fig. 7. The solar cell pieces 10a, 10b and 10c may be grouped together, or rejoined, in a configuration which may be substantially similar to the shape of the original solar cell 1 held by the holding members before cleaving. Adjacent solar cell pieces may be in contact with each other so that the total area taken up by the solar cell pieces 10a, 10b and 10c is substantially the same as the area of the initial solar cell 1 before cleaving. Alternatively, a small distance can be provided between adjacent solar cell pieces, e.g. a distance of a up to few millimeters, for example 0.2 mm to 2 mm. This may be achieved by an additional horizontal translation movement of the holding members to spread out the solar cell pieces from each other.

One or more holding members, such as for example the holding member 510 and the holding member 530, of the cleaving system may each have a respective rotation axis. Optionally, the rotation axis of a holding member and a solar cell (or solar cell piece) supported by the holding member may be disposed in a substantially same plane. The rotation axis may be disposed in a plane defined by the solar cell (or solar cell piece) held by the holding member, for example a plane defined by a bottom surface of the solar cell (or solar cell piece). Before the solar cell is cleaved, the rotation axes of the holding members and the solar cell held by the holding members may be disposed in a substantially same plane. In light of the position of the rotation axes in a substantially same plane as the solar cell, when performing the first rotation movement of the holding members to cleave the solar cell, the solar cell is only cleaved by pure rotational forces and is not subject to ripping forces ripping the material of the solar cell apart. The solar cell can be accurately cleaved along the scribing lines of the solar cell. Irregularities along the edges of the solar cell pieces can be reduced.

In comparison, if the rotation axis of a holding member is disposed at a substantial vertical offset below the solar cell held by the holding member before the solar cell is cleaved, the subsequent rotation of the holding member for cleaving the solar cell will cause a horizontal force to act on the solar cell (for example, if the holding member rotates counter-clockwise, the horizontal force will act towards the left). Rather than a cleaving by a pure rotation, the solar cell will be subject to ripping forces, i.e. the material of the solar cell will be ripped apart in a horizontal direction. Further, when considering the normal nominal tension profile of the solar cell at the scribed line (i.e. the gradient of the tension in a horizontal direction present in the material of the solar cell between the scribed line and the bottom of the solar cell), it is found that the maximum tension of said tension profile, being the tension that is present at the bottom of the scribe line, is smaller than the maximum tension in a configuration where the rotation axis and the solar cell are disposed in the same plane. In light of such relatively small tension, the crack in the solar cell material generated by the rotation movement of the holding member will not start precisely at the bottom of the scribe line but may deviate therefrom. The separation surfaces at the edges of the resulting solar cell pieces may be irregular.

When the solar cell is held by the holding members of the cleaving system, each rotation axis of a respective holding member may face, i.e. be directly in front of, a scribed line of the solar cell. A horizontal distance between the holding member and the scribed line may be substantially zero. The solar cell can be accurately cleaved along the scribing lines. Irregularities along the edges of the solar cell pieces can be reduced. The quality of the cleaving can be improved.

In comparison, if a horizontal offset exists between the location of the scribed lined and the position of the rotation axis of the corresponding holding member, the rotation of the holding member may cause an upward force to act on the solar cell at the location of the scribed line. The solar cell may not be cleaved by a pure rotation. The solar cell may at least in part be cleaved due to an upward shear stress acting on the material of the solar cell at the scribed line. As a result, instead of exhibiting a cleaving by the formation of a crack originating at the bottom of the scribed line, the material of the solar cell may be ripped apart due to the shear stresses without the formation of a crack or at best with a crack that propagates only slowly. The separation surfaces at the edges of the resulting solar cell pieces may be irregular.

In embodiments described herein where the rotation axis of a holding member is disposed in a substantially same plane as the solar cell, and wherein additionally the scribed line is facing the rotation axis such that a horizontal distance between the scribed line and the rotation axis is substantially zero, the rotation of the holding member will result in the generation of a crack in the solar cell, which will start precisely at the bottom of the scribed line. Further, the crack will propagate fast since all stresses are purely normal and tractional. The crack will propagate from the bottom of the scribed line to the bottom surface of the solar cell in a direction perpendicular to the solar cell. The separation surfaces at the edges of the resulting solar cell pieces will be regular. In turn, a rejoining movement for bringing the solar cell pieces together after cleaving can be facilitated.

Further, if the rotation axes of the holding members are disposed in a substantially same plane as the solar cell, a shifting of the position of the solar cell with respect to the holding members during cleaving can be reduced or even avoided. The positions of the solar cell pieces relative to the holding members can be substantially identical to the initial positions of corresponding portions of the solar cell with respect to the holding members before the cleaving was performed. In light of the fact that positional shifting of the solar cell (pieces) can be reduced or even avoided, the rejoining of the solar cell pieces can be facilitated. For example, by performing the second rotation movement as the inverse of the first rotation movement, the solar cell pieces may be returned in a configuration which substantially corresponds to the initial position of the solar cell on the holding members before cleaving.

In an example not being part of the present invention, a rotation axis of a holding member may be disposed at an offset with respect to the solar cell or solar cell piece in a direction perpendicular to the solar cell or solar cell piece, for example an offset of 5 mm or more. For example, according to some embodiments described herein, after the solar cell is cleaved, one or more holding members holding one or more respective solar cell pieces can be subject to an alignment movement which may be controlled by a controller connected to the cleaving system. In examples not being part of the present invention and involving such an alignment movement, the aspect according to which a rotation axis of a holding member is disposed in a substantially same plane as the solar cell or solar cell piece held by the holding member may be omitted. In such cases, even where the rotation axis is disposed at a substantial offset relative to the solar cell, for example an offset of 5 mm, a potential shifting of the position of a solar cell (piece) with respect to a holding member arising from the offset position of the rotation axis can be compensated by the subsequent alignment movement.

After performing the first rotation movement, or cleaving movement, and before performing the second rotation movement, or rejoining movement, a stream of air (or another gas) may be provided in regions between adjacent solar cell pieces. For example, air may be blown in a first region between solar cell piece 10a and solar cell piece 10b, and/or in a second region between solar cell piece 10b and solar cell piece 10c. The air may travel upward, e.g. from a position below the solar cell pieces to a position above the solar cell pieces, or downward, e.g. from a position above the solar cell pieces to a position below the solar cell pieces. A gas stream such as an air stream may be provided by a gas stream source, e.g. a source configured to blow a stream of gas. For example, in the vicinity of the first region and the second region, a respective gas stream source may be disposed. An air stream may be directed at an edge of a solar cell piece. An air stream may remove small debris particles that may have been generated in the cleaving process, for example debris particles remaining at the edges of the solar cell pieces after the cleaving, i.e. after the first rotation movement. By removing the debris particles, irregularities at the edges of the solar cell pieces may be removed. Before the solar cell pieces are rejoined. The rejoining of the solar cell pieces may be facilitated, particularly in cases where the rejoining involves bringing adjacent solar cell pieces in contact or near-contact with each other.

After the solar cell pieces 10a, 10b, 10c of the solar cell 1 have been arranged in a target position as shown in Fig. 7, the solar cell pieces are jointly moved to a first deposition area 810 of a deposition station 800, as shown in Fig. 8. The top portion of Fig. 8 shows a side view of a deposition station 800 including a first deposition head 820 facing the first deposition area 810. The first deposition head 820 may be a printing head, such as a screen printing head. The solar cell pieces 10a, 10b and 10c are jointly supported by a support 830 of the deposition station 800. The support 830 may hold the solar cell pieces 10a, 10b and 10c by applying a holding force, e.g. a suction force, to the solar cell piece. The first deposition area 810 may be an area of, or may be an area defined by, the support 830. The lower portion of Fig. 8 shows a top view of the first deposition area 810. The solar cell pieces 10a, 10b, 10c may be jointly disposed next to each other in the first deposition area 810. Using the first deposition head 820, i.e. one common deposition head facing the first deposition area 810, one or more features may be deposited on each of the solar cell pieces 10a, 10b, and 10c while the solar cell pieces 10a, 10b, and 10c are disposed together in the first deposition area 810. The deposition of the respective features is illustrated in Fig. 8 by the dashed lines emanating from the first deposition head 820. For example, an adhesive 30a, 30b and 30c can be deposited on the solar cell pieces 10a, 10b, and 10c, respectively, while the solar cell pieces 10a, 10b, and 10c are disposed together in the first deposition area 810. According to embodiments, the respective features can be deposited in parallel on the solar cell pieces 10a, 10b, and 10c disposed in the first deposition area 810, as illustrated in Fig. 8.

The exemplary cleaving system 500 shown in Figs. 5-7 has three holding members for cleaving a solar cell 1 into three solar cell pieces. The present disclosure is not limited thereto. The cleaving system 500 may include two, three, four, five, six or more holding members. The solar cell 1 may be cleaved into two, three, four, five, six or more solar cell pieces. In Figs. 5-7, the holding member 520 is stationary. The disclosure is not limited thereto. All holding members of the cleaving system may be movable, particularly rotatable.

In the exemplary configuration shown in Fig. 8, all solar cell pieces 10a, 10b and 10c of the solar cell 1 are arranged jointly in the first deposition area 810. The present disclosure is not limited thereto. A subset of the solar cell pieces of the solar cell (such as the solar cell piece 10a and the solar cell piece 10b only, without the solar cell piece 10c) may be jointly disposed in the first deposition area 810 for depositing respective features, e.g. adhesives, on the subset of solar cell pieces.

Embodiments described herein involve a deposition of features, such as adhesives, on solar cell pieces. The features in question are deposited after cleaving of the solar cells. Further, the solar cell pieces originating from a same solar cell are handled and processed together. In particular, the adhesives can be deposited in parallel on solar cell pieces which originate from the same solar cell. Embodiments described herein thus allow depositing features on individual solar cell pieces, i.e. after cleaving of the solar cells, while maintaining a high throughput, since multiple solar cell pieces of a same solar cell can be processed together. Further, after cleaving, the method may proceed directly to the deposition of the adhesives, i.e. the solar cell pieces can be moved directly from the cleaving position to the deposition area for depositing the adhesives. There may be no need for collecting, i.e. storing or buffering, the solar cell pieces between the cleaving and the deposition of the adhesives.

A method as described herein may include depositing, while all solar cell pieces of the solar cell are in the same deposition area, one or more respective features on each solar cell piece of the plurality of solar cell pieces.

The one or more first features and the one or more second features may be deposited by a first deposition head facing the first deposition area. A method as described herein may include jointly supporting the first solar cell piece and the second solar cell piece by a support so that the first deposition head faces both the first solar cell piece and the second solar cell piece supported by the support, particularly such that the first deposition head faces all solar cell pieces of the plurality of solar cell pieces supported by the support.

The one or more first features and the one or more second features may be deposited in parallel on the first solar cell piece and the second solar cell piece, respectively. Depositing the one more first features and the one or more second features may include printing, particularly screen printing, the one or more first features and the one or more second features. The one or more first features may include a first adhesive and the one or more second features may include a second adhesive.

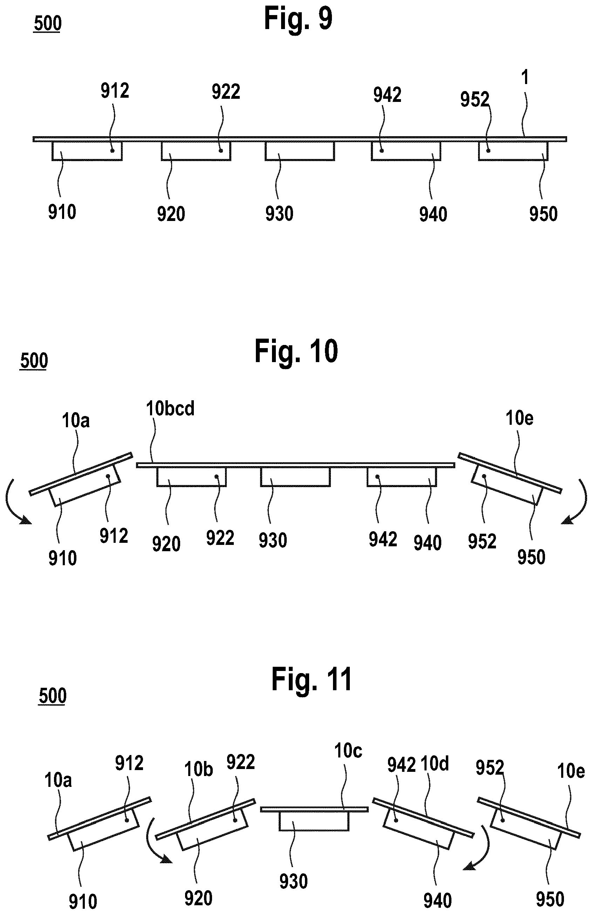

Fig. 9 shows an example of a cleaving system 500, or separation system, as described herein. The cleaving system 500 is configured for separating a solar cell into a plurality of solar cell pieces.

The cleaving system 500 may include a plurality of holding members. The holding members may be elongated members which may be substantially parallel to each other. The plurality of holding members may include three, four, five, six or more holding members. For example, as shown in Fig. 9, the cleaving system 500 may include a holding member 910, a holding member 920, a holding member 930, a holding member 940 and/or a holding member 950.

A solar cell 1, i.e. a full solar cell, may be supported jointly, i.e. simultaneously, by the plurality of holding members. A first portion of the solar cell 1 can be supported by a first holding member, e.g. holding member 910. A second portion of the solar cell 1 can be supported by a second holding member, e.g. holding member 920. Each holding member of the plurality of holding members 910, 920, 930, 940 and 950 can support a respective portion of the solar cell 1.

A holding member as described herein may be configured to apply a holding force to a solar cell or solar cell piece supported by the holding member. For example, the holding force may be a suction force. A holding member may include one or more suction openings or suction cups which may be connectable to a vacuum source system. At the one or more suction openings or suction cups, a suction force may be applied to hold the solar cell or solar cell piece supported by the holding member. The example of the holding force being a suction force is just an example and the disclosure is not limited thereto.

A holding member as described herein may have a receiving surface for receiving at least a portion of a solar cell or solar cell piece. According to some embodiments, a solar cell or solar cell piece held by the holding member may be on top of the receiving surface. In some embodiments, the receiving surface may be an upward-facing surface. According to other embodiments, the receiving surface may be a downward-facing surface, e.g. including downward-facing suction openings or suction cups, as described in more detail below.

One or more holding members of the cleaving system 500 may be movable holding members. While the solar cell 1 is held, e.g. by suction, by the holding members at respective portions of the solar cell 1, one or more of the holding members may be moved in order to cleave the solar cell i.e. separate the solar cell 1 into a plurality of solar cell pieces. The movement of the holding members to separate the solar cell 1 may include a rotational or pivoting movement which results in a breaking of the solar cell.

The plurality of holding members may include two or more movable holding members. For example, in the cleaving system 500 shown in Figs. 9-11, the holding member 910, the holding member 920, the holding member 940, and/or the holding member 950 may be movable holding members. The holding members 910, 920, 940 and/or 950 may be rotatable around respective rotation axes 912, 922, 942 and 952. The rotation axes 912, 922, 942 and 952 of the respective holding members may be substantially parallel to each other. Substantially parallel axes, directions, orientations and the like include a possible deviation of up to 15 degrees from exactly parallel axes, directions, orientations and the like.

For the sake of simplicity of presentation, Fig. 9 shows the rotation axes 912, 922, 942 and 952 at a vertical offset below the solar cell 1. It shall be understood that the rotation axes 912, 922, 942 and 952 of the cleaving system shown in Fig. 9 (and likewise Figs. 10-13) can be disposed in a substantially same plane as the solar cell 1, i.e. the horizontal plane defined by the solar cell 1 shown in Fig. 9. According to embodiments described herein, the first holding member may be rotatable about a first rotation axis. The first rotation axis and the solar cell held by the plurality of holding members may be disposed in a substantially same plane. A first distance between the first rotation axis and the solar cell held by the plurality of holding members may be from 0 to 2 mm, particularly from 0 to 1 mm. The first distance may be a distance in a direction perpendicular to the solar cell. The second holding member may be rotatable about a second rotation axis. The second rotation axis and the solar cell held by the plurality of holding members may be disposed in a substantially same plane. A second distance between the second rotation axis and the solar cell held by the plurality of holding members may be from 0 to 2 mm, particularly from 0 to 1 mm. The second distance may be a distance in a direction perpendicular to the solar cell. The third holding member may be rotatable about a third rotation axis. The third rotation axis and the solar cell held by the plurality of holding members may be disposed in a substantially same plane. A third distance between the third rotation axis and the solar cell held by the plurality of holding members may be from 0 to 2 mm, particularly from 0 to 1 mm. The third distance may be a distance in a direction perpendicular to the solar cell. The first, second and/or third distance may be zero.

A rotation axis of a holding member as described herein may be a substantially horizontal axis. A substantially horizontal axis, direction, orientation and the like may include a possible deviation of up to 15 degrees with respect to an exactly horizontal axis, direction or orientation.

One or more holding members, such as for example the holding member 930 shown in Fig. 9, may be stationary holding members. A stationary holding member like the holding member 930 may operate differently from a movable holding member like the holding member 910. A stationary holding member may remain in a fixed position. A stationary holding member may not be configured to perform a rotation. Alternatively, all holding members of the cleaving system may be movable holding members.

The cleaving system 500 shown in Figs 9-11 may operate to cleave a solar cell 1 as described in the following.

As shown in Fig, 9, before the cleaving is performed, a solar cell 1 may be supported by the holding members 910, 920, 930, 940 and 950. The solar cell may be supported by the holding members in a manner such that each scribed portion of the solar cell faces a rotation axis of a respective holding member. Each scribed portion, particularly each scribed line, may face and/or be parallel to a rotation axis of a respective holding member. The front side of the solar cell may face downward. A first portion of the solar cell 1 may be held, e.g. suctioned, by the holding member 910; a second portion of the solar cell 1 may be held, e.g. suctioned, by the holding member 920; and so on. Each holding member may apply a holding force to a respective portion of the solar cell 1. The holding members shown in Fig. 9 are in an initial position. The receiving surface of each holding member may be substantially horizontal. The receiving surfaces of the holding members may be substantially parallel to each other.

As shown in Fig. 10, in a first phase of operation, the holding member 910 may perform a first movement, particularly a first rotation movement around the rotation axis 912, relative to the holding member 920. The holding member 910 may rotate in a counter-clockwise sense. During the first movement, a holding force may continue to be applied by at least the holding members 910 and 920, particularly by all holding members 910, 920, 930, 940 and 950. During the first movement of the holding member 910, at least the holding member 920 may remain in an initial position. The receiving surface of the holding member 920 may remain substantially horizontal while the holding member 910 performs the first movement. As the holding member 910 moves farther away from an initial position, e.g. by rotating around the rotation axis 912, the solar cell 1 may be cleaved. A solar cell piece 10a may be broken off on the left side of the solar cell by the rotation of the holding member 910.

In the first phase of operation, the holding member 950 may perform a first movement similar to the first movement of the holding member 910, albeit that the holding member 950 may rotate in a different sense. The first movement of the holding member 950 may be a rotational movement around the rotation axis 952, particularly a movement relative to the holding member 940. The holding member 950 may rotate in a clockwise sense. During the first movement of the holding member 950, the holding member 940 may remain in an initial position. The receiving surface of the holding member 940 may remain substantially horizontal while the holding member 950 performs the first movement. As the holding member 950 moves farther away from an initial position, e.g. by rotating around the rotation axis 952, the solar cell 1 may be cleaved. A solar cell piece 10e may be broken off on the right side of the solar cell by the rotation of the holding member 950.

The first movements of the holding members 910 and 950 may be performed simultaneously. During the first movement of the holding members 910 and/or 950, the holding member 920, the holding member 930 and/or the holding member 940 may remain stationary so that the receiving surfaces of these holding members may remain substantially horizontal.

The first movements of the holding member 910 and the holding member 950 may result in two solar cell pieces 10a and 10e being broken off at the left and right end of the solar cell 1, respectively. A middle portion 10bcd of the solar cell may continue to be supported by the holding member 920, the holding member 930 and the holding member 940. After the first phase is completed, the holding member 910 and the holding member 950 may each hold a respective solar cell piece 10a and 10e, e.g. by suction.

As shown in Fig. 11, a second phase of operation may be performed after the first phase. The holding member 920 may perform a first movement in a counter-clockwise sense, similar to the first movement of the holding member 910. The holding member 940 may perform a first movement in a clockwise sense, similar to the first movement of the holding member 950. The holding members 920 and 940 may rotate around the rotation axes 922 and 942, respectively. During the first movement of the holding members 920 and/or 940, the holding member 930 may remain stationary. The receiving surface of the holding member 930 may be kept substantially horizontal during the first movement of the holding member 920 and/or the first movement of the holding member 940. The first movements of the holding members 920 and 940 may be performed simultaneously. The first movements of the holding members 920 and 940 may result in two solar cell pieces 10b and 10d of the portion 10bcd being broken off. Another solar cell piece 10c may be held by the holding member 930.

After the second phase, each of the holding members 910, 920, 930, 940 and 950 may hold a respective solar cell piece. The solar cell 1 has been separated into a plurality of solar cell pieces, in this example five solar cell pieces. A solar cell piece 10a is held by the holding member 910. A solar cell piece 10b is held by the holding member 920. A solar cell piece 10c is held by the holding member 930. A solar cell piece 10d is held by the holding member 940. A solar cell piece 10e is held by the holding member 950. Each solar cell piece held by a respective holding member corresponds to a portion of the solar cell initially held by the holding member in question.

A movement of a holding member which is performed to cleave a solar cell shall be referred to herein as a cleaving movement of the holding member. For example, the first movement of the holding member 910, e.g. a rotation in a counter-clockwise sense as illustrated in Fig. 10, can be understood as a cleaving movement of the holding member 910. Likewise, the respective first movements of the holding member 920 (e.g. a counter-clockwise rotation), the holding member 940 (e.g. a clockwise rotation) and the holding member 950 (e.g. clockwise rotation) can be understood as cleaving movements.

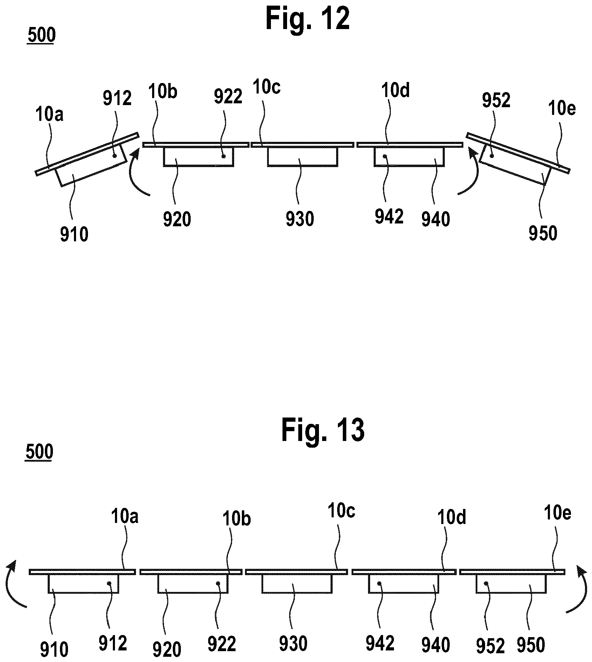

After the solar cell is cleaved into a plurality of solar cell pieces, one or more of the solar cell pieces which are held by the respective holding members may be arranged into a target position by performing a second movement of one or more holding members, as illustrated in Figs. 12-13.

As shown in Fig. 12, a third phase of operation may be performed after the second phase. The holding member 920 may perform a second movement to arrange the solar cell piece 10b held by the holding member 920 in a target position. The second movement may be performed to position the receiving surface of the holding member 920 in a substantially horizontal orientation. After the second movement, the receiving surface of the holding member 920 may be substantially in an initial position, i.e. the position of the holding member 920 as shown in Fig. 9. The second movement of the holding member 920 may be a second rotation movement. The holding member 920 may be rotated around the rotation axis 922. In the second movement, the holding member 920 may be rotated in a clockwise sense, i.e. a sense opposite to the first movement of the holding member 920.

In the third phase of operation, the holding member 940 may perform a second movement. The holding member 940 may perform a second movement to arrange the solar cell piece 10d held by the holding member 940 in a target position. The second movement of the holding member 940 may be performed to position the receiving surface of the holding member 940 in a substantially horizontal orientation. The second movement of the holding member 940 may be a rotation movement. The holding member 940 may be rotated around the rotation axis 942. In the second movement, the holding member 940 may be rotated in a counter-clockwise sense, i.e. a sense opposite to the first movement of the holding member 940.

The second movements of the holding members 920 and 940 may be performed simultaneously. During the second movements of the holding members 920 and/or 940, the holding member 910, the holding member 930 and/or the holding member 950 may remain stationary. The receiving surface of the holding member 910 and the holding member 950 may remain in an angled orientation with respect to a horizontal direction, as shown in Fig. 12. The receiving surface of the holding member 930 may remain in a substantially horizontal orientation.

As shown in Fig. 13, a fourth phase of operation may be performed after the third phase. The holding member 910 may perform a second movement, for example a rotation in a clockwise sense, similar to the second movement of the holding member 920. The holding member 950 may perform a second movement, for example a rotation in a counter-clockwise sense, similar to the movement of the holding member 940. The holding member 910 and the holding member 950 may rotate around the rotation axes 912 and 952, respectively. During the second movement of the holding members 910 and/or 950, the holding member 920, the holding member 930 and/or the holding member 940 may remain stationary. The receiving surfaces of the holding member 920, the holding member 930 and/or the holding member 940 may be kept substantially horizontal during the second movement of the holding member 910 and/or the holding member 950. The second movements of the holding members 910 and 950 may be performed simultaneously.

As shown in Fig. 13, after the fourth phase, each of the holding members may hold a respective solar cell piece in a substantially horizontal orientation. The solar cell pieces may be arranged adjacent to each other in a configuration corresponding to the shape of the solar cell 1 before the cleaving. Adjacent solar cell pieces may be in contact with each other. Alternatively, a small gap may be provided between adjacent solar cell pieces. The gap can be provided by moving the holding members 910, 920, 940 and/or 950 apart from each other, for example before or after performing the second movements of the respective holding members.

A movement of the holding members as described for example with respect to Figs. 12-13 is referred to herein as a rejoining movement of the holding members. A rejoining movement of a holding member can be understood as a movement in a sense opposite to a cleaving movement of the holding member. By performing a rejoining movement, a solar cell piece held by the holding member may be brought into a substantially horizontal orientation. The rejoining movements of the holding members may be performed to bring the solar cell pieces in a configuration which substantially corresponds to the shape of the initial solar cell 1 before cleaving. A second movement of a holding member, as described herein, can be understood as a rejoining movement of the holding member.

A solar cell as described herein may be separated into a plurality of solar cell pieces by a cleaving system. The cleaving system may include a plurality of holding members including a first holding member and a second holding member. A method according to embodiments described herein may include holding the solar cell by the plurality of holding members. The method may include performing a first movement of the first holding member relative to the second holding member to cleave the solar cell. The first movement of the first holding member may include a movement over an angle. The first movement may be a first rotation movement as described herein. During the first movement of the first holding member, a holding force, e.g. a suction force, may be applied by the first holding member and the second holding member.

For the sake of concreteness, the first solar cell piece as described herein can be understood as the solar cell piece 10a, the second solar cell piece can be understood as the solar cell piece 10b, the first holding member can be understood as the holding member 510 or the holding member 910, and the second holding member can be understood as the holding member 520 or the holding member 920. This is just an example and the disclosure is not limited thereto, and it shall be understood that the first solar cell piece, the second solar cell piece, the first holding member and the second holding member can be taken to correspond to other solar cell pieces and holding members, respectively, as described herein and shown in the figures.

The first holding member may be a movable holding member, e.g. a rotatable holding member. The first holding member may be movable, e.g. rotatable, with respect to the second holding member. The first holding member may be rotatable around a rotation axis.

The second holding member may be a movable holding member, particularly a rotatable holding member (e.g. holding member 920). The second holding member may be movable, e.g. rotatable, with respect to the first holding member. The second holding member may be rotatable around a rotation axis. Alternatively, the second holding member may be a stationary holding member (e.g. holding member 520).

A method according to embodiments described herein may include holding the first solar cell piece (e.g. the solar cell piece 10a) by the first holding member after the first movement of the first holding member, as shown for example in Fig. 11. The method may include holding the second solar cell piece (e.g. the solar cell piece 10b) by the second holding member after the first movement of the first holding member, as shown for example in Fig. 11. The first solar cell piece may be arranged in a target position by performing a second movement of the first holding member holding the first solar cell piece, as shown for example in Fig. 13. The second movement of the first holding member may be performed after the first movement of the first holding member. During the second movement of the first holding member, a holding force, e.g. a suction fore, may be applied to the first solar cell piece by the first holding member.

The first movement may include moving the first holding member from a first position to a second position to cleave the solar cell, e.g. a counter-clockwise rotation of holding member 910. The second movement may include moving the first holding member from the second position in a sense opposite to the first movement, e.g. a clockwise rotation of the holding member 910, to position the first solar cell piece in the target position. The second movement may include moving the first holding member from the second position towards or into the first position.

The first movement of the first holding member may include moving the first holding member over an angle to cleave the solar cell. The second movement may include moving the first holding member over an angle in a sense opposite to the first movement to position the first solar cell piece in the target position of the first solar cell piece. The second movement may be a second rotation movement as described herein.

The plurality of holding members may include three, four, five, six of more holding members. Each holding member of the plurality of holding members may be configured to apply a holding force, particularly a suction force, to the solar cell. Each holding member may be connectable to a vacuum source. Each holding member, or at least two, three or four holding members, may have a rotation axis. The rotation axes of two or more, e.g. three or four or more, holding members may be substantially parallel to each other. A rotation axis may be a substantially horizontal axis. A first movement of a holding member may include a rotation about the rotation axis of the holding member. A second movement of a holding member may include a rotation about the rotation axis of the holding member in a sense opposite to the first movement.

A cleaving system 500 as described herein may include an actuator system including one or more actuators. The actuator system is connected to one or more holding members (e.g. the first holding member, the second holding member and/or the third holding member as described herein) of the cleaving system 500. The actuator system may cause one or more holding members to perform a first movement, a second movement, an alignment movement and/or a translation movement as described herein. The actuator system may include, for example, a pneumatic actuator, a linear motor, or a recirculating ball screw motor. For example, in relation to Figs. 9-13, the actuator system may be connected to the holding member 910, the holding member 920, the holding member 940 and/or the holding member 950. The actuator system may cause the first rotation movement (cleaving movement) of the holding members 910, 920, 940 and/or 950. The actuator system may cause the second rotation movement (rej oining movement) of the holding members 910, 920, 940 and/or 950.

The second movement of any holding member of the cleaving system may be performed under the control of a controller of, or connected to, the cleaving system. For example, the second movement of the first holding member may be performed under the control of a controller connected to the cleaving system.

A cleaving system as described herein may include or be connected to a controller. The controller may be connected to the actuator system. At least the second movement of a holding member (e.g. the first holding member, the second holding member and/or the third holding member) may be performed under the control of the controller. Controlling the second movement may ensure that the solar cell piece held by the holding member is accurately positioned in a target position. An accurate rejoining movement can be provided. Additionally or alternatively, an alignment movement of one or more holding members (e.g. the first holding member, the second holding member and/or the third holding member) as described herein can be performed under the control of the controller. The controller may be connected to an inspection unit as described herein. The controller may be configured to control the second movement of a holding member and/or an alignment movement of the holding member based on inspection data provided by the inspection system, for example based on an image of the solar cell or solar cell pieces supported by the cleaving system.

Likewise, according to some embodiments, the first movement (or cleaving movement) of a holding member can be performed under the control of the controller.

A method as described herein may include: performing an alignment movement of the first holding member holding the first solar cell piece to align the first solar cell piece; performing an alignment movement of the second holding member holding the second solar cell piece to align the second solar cell piece; performing an alignment movement of the third holding member holding the third solar cell piece to align the third solar cell piece; and any combination thereof.

A method as described herein includes performing an alignment movement of one or more holding members, particularly two, three, four or more or more holding members. For example, an alignment movement of holding member 910, holding member 920, holding member 940 and/or holding member 950 may be performed. An alignment movement may include adjusting a position, e.g. a horizontal position, of the holding member to align a solar cell piece held by the holding member. The alignment of a solar cell piece includes an alignment of the solar cell piece with respect to another solar cell piece, for example an adjacent solar cell piece held by an adjacent holding member, and/or an alignment of the solar cell piece with respect to one or more alignment marks or alignment features. The alignment movement may include moving the holding member over a horizontal distance and/or moving the holding member over an angle relative to a vertical rotation axis. The alignment movement is performed after the second movement of the holding member. The alignment movement is performed under the control of a controller as described herein. The cleaving system may include one or more alignment actuators for performing the alignment movement of the holding member(s). The one or more alignment actuators may be connected to the controller.

In other words, according to embodiments described herein, the cleaving system can be used for aligning the solar cell pieces. There may be no need to transfer the solar cell pieces from the cleaving system to different area or device for aligning the solar cell pieces.

As described above, in embodiments involving an alignment operation of one or more holding members, the aspect according to which a rotation axis of a holding member is disposed in a substantially same plane as the solar cell or solar cell piece held by the holding member may be included or may be omitted.

A method according to embodiments described herein may include providing a gas stream, for example an air stream, between adjacent solar cell pieces of the plurality of solar cell pieces. The method may include providing a gas stream in a region between the first solar cell piece and the second solar cell piece. The gas stream may be directed at a first edge of the first solar cell piece and/or at a second edge of the second solar cell piece. The gas stream may be provided after performing the first movement (cleaving movement) and/or before performing the second movement (rejoining movement). Debris particles can be removed. The rejoining of the solar cell pieces can be facilitated.

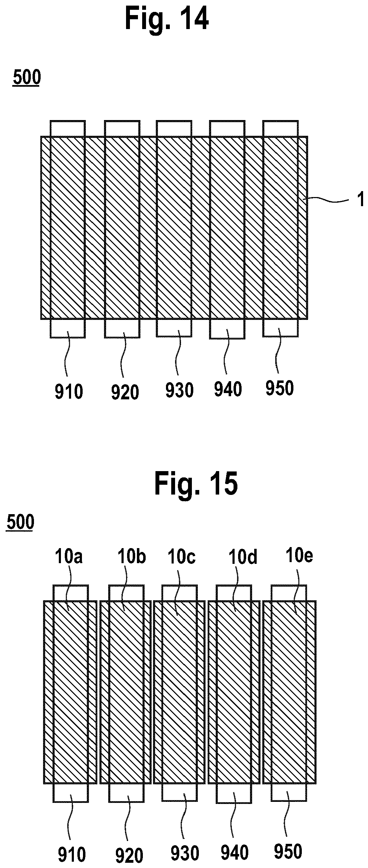

Fig. 14 shows a top view of a solar cell 1 held by the holding members before cleaving, similar to the configuration shown in Fig. 9 in a side view. Fig. 15 shows a top view of the solar cell pieces 10a, 10b, 10c, 10d and 10e held by the respective holding members after cleaving of the solar cell 1 and after rejoining of the holding members, similar to the configuration shown in Fig. 13 in a side view. As shown in Figs. 14 and 15, the shape formed by the solar cell pieces jointly after rejoining is substantially the same as the shape of the solar cell 1 before cleaving.

As described herein, a holding member, such as for example the first holding member, the second holding member and/or the third holding member, may be rotatable around a rotation axis. Additionally, the holding member may be configured to perform a translation. A holding member may be translatable in a horizontal direction. A translation of the holding member may be performed after the first movement of the holding member, particularly after a first rotation movement as described herein. A translation of the holding member may be performed after the second movement of the holding member, particularly after a second rotation movement as described herein. A translation movement of a holding member may be a translation in a direction substantially perpendicular to a rotation axis of the holding member. A translation movement of a holding member may be performed to increase a horizontal distance between the holding member and an adj acent holding member of the cleaving system.

For example, in the cleaving system 500 shown in Figs. 9-13, the holding member 910 may be translated towards the left to increase a horizontal distance between the holding member 910 and the holding member 920. The holding member 920 may be translated towards the left to increase a horizontal distance between the holding member 920 and the holding member 930. The holding member 940 may be translated towards the right to increase a horizontal distance between the holding member 930 and the holding member 940. The holding member 950 may be translated towards the right to increase a horizontal distance between the holding member 940 and the holding member 950.

At least one of the holding members of the cleaving system may be translated in a horizontal direction to move adjacent holding members apart from each other. After the translation movement, an offset, i.e. a gap, may be provided between adjacent solar cell pieces held by respective adjacent holding members. The translation movement may be performed after the first movement of the holding members, e.g. after reaching the configuration shown in Fig. 11, or even after the second movements, e.g. after reaching the configuration shown in Fig. 13.

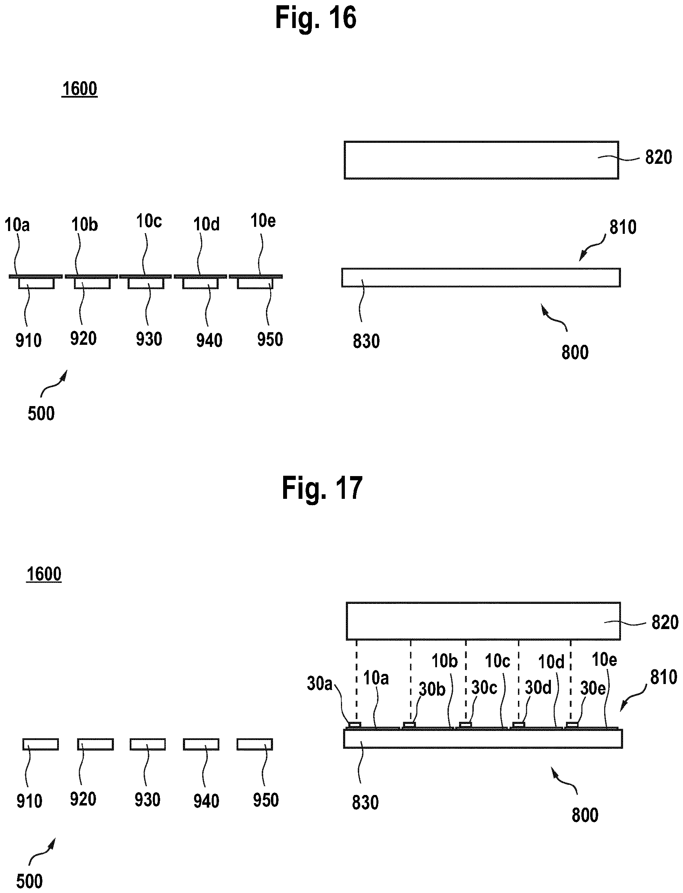

Figs. 16-17 show an apparatus 1600 for processing solar cells according to embodiments described herein. The apparatus 1600 includes a cleaving system 500 as described herein. The apparatus 1600 includes a deposition station 800, as described herein, downstream of the cleaving system 500. The deposition station 800 has a first deposition area 810 and a first deposition head 820 facing the first deposition area 810.

Fig. 16 shows the cleaving system 500 in a state of operation similar to Fig. 13, after rejoining of the holding members. After cleaving and/or after rejoining, the solar cell pieces may be moved to the first deposition area 810.

In the method of the invention, as illustrated in Fig. 17, the solar cell pieces are moved from the cleaving system 500 to the first deposition area 810. The solar cell pieces are lifted from the holding members by a gripper (not shown). The gripper must be adapted for gripping multiple solar cell pieces simultaneously. The solar cell pieces are transported to the first deposition area 810 by the gripper.

In examples not being part of the present invention, the cleaving system may transport the solar cell pieces to the first deposition area 810. For example, the cleaving system shown in Fig. 16 may be movable over a horizontal distance for transporting the solar cell pieces to the first deposition area 810. The support 830 may then be omitted, and the holding members of the cleaving system may function as a support during deposition.

After the solar cell pieces have been moved to the first deposition area 810, one or more respective features, e.g. adhesives, may be deposited by the first deposition head 820 on the solar cell pieces, as illustrated by the dashed lines in Fig. 17. For example, an adhesive 30a, 30b, 30c, 30d and 30e may be deposited on the solar cell piece 10a, 10b, 10c, 10d and 10e, respectively. The features may be deposited, e.g. printed, in parallel on the solar cell pieces that are disposed in the first deposition area 810. The respective features may be printed in parallel in one common printing stroke of the first deposition head 820. After the deposition process, a solar cell piece may be similar to the solar cell piece shown in Fig. 3.

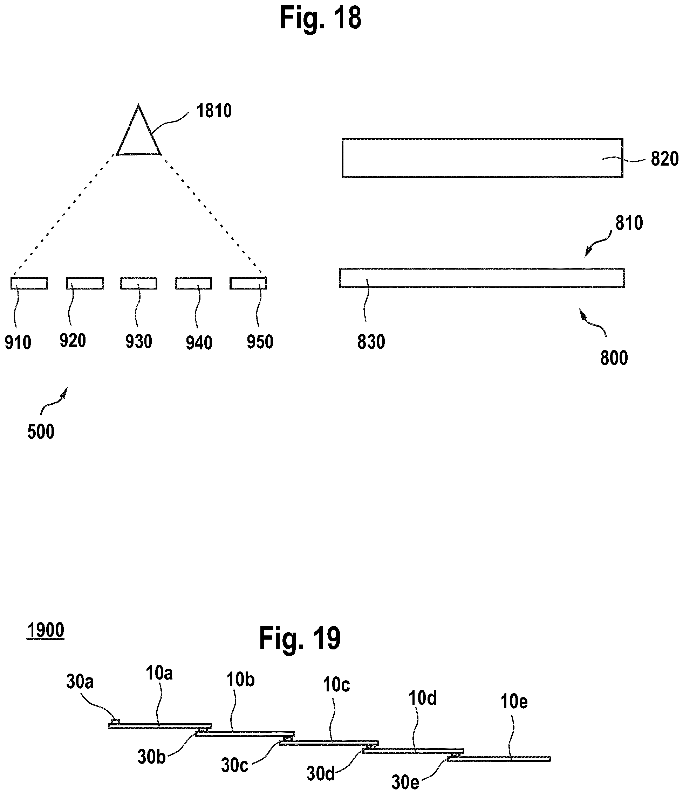

As shown in Fig. 18, an apparatus 1600 according to embodiments described herein may include an inspection unit 1810. The inspection unit 1810 may be arranged to inspect a solar cell or one or more solar cell pieces held by the cleaving system 500. The inspection unit may, for example, include a camera to create an image of the solar cell or the one or more solar cell pieces. The inspection unit may be connected to a controller as described herein.

The inspection unit 1810 may be configured to perform a first inspection. In the first inspection, the inspection unit 1810 may inspect a solar cell held by the cleaving system before the solar cell is cleaved by the cleaving system 500. The solar cell 1 may be inspected to determine a position of the solar cell 1 on the holding members of the cleaving system 500.

Additionally or alternatively, the inspection unit 1810 may be configured to perform a second inspection. In the second inspection, the inspection unit 1810 may inspect the solar cell pieces held by the holding members after one or more holding members have performed the first movement (cleaving movement) as described herein, or after one or more holding members have performed a second movement (rejoining movement) as described herein. For example, the second inspection may be performed to determine whether an error has occurred during cleaving, for example whether the solar cell was cleaved along the predetermined cleaving line provided by the scribing, or whether one or more solar cell pieces were damaged during the cleaving operation, or whether the rejoining has been performed correctly, e.g. whether the solar cell pieces have been correctly arranged in their target positions in the rejoining movement. If it is determined, based on the second inspection, that one or more solar cell pieces are not suitable for being further processed, the solar cell pieces in question may be discarded.

Before the features, e.g. adhesives, are deposited on the solar cell pieces that are disposed in the first deposition area, a position of the first deposition head 820 may be adjusted to align the first deposition head 820 with respect to one or more of the solar cell pieces. For example, the first deposition head 820 may be aligned with respect to one or more busbars of one or more solar cell pieces. The alignment of the first deposition head 820 may be performed based on inspection data provided by an inspection unit as described herein, for example inspection data obtained in a second inspection as described herein.

A method according to embodiments described herein may include, after the second movement of at least one of the first holding member and the second holding member, jointly transferring the first solar cell piece and the second solar cell piece from a cleaving position to the first deposition area. The cleaving position can be understood as the position or area in which the solar cell pieces are arranged during cleaving, e.g. the position of the cleaving system as shown in Fig. 16. A relative position of the first solar cell piece and the second solar cell piece may be maintained during the transferring of the first solar cell piece and the second solar cell piece from the cleaving position to the first deposition area. The second movement (rejoining movement) may result in well-aligned solar cell pieces. After the second movement, no further alignment of the solar cell pieces may be performed prior to deposition of the features on the solar cell pieces.

After the adhesives have been deposited, e.g. printed, on the solar pieces of the solar cell 1 that are disposed in the first deposition area 810, the solar cell pieces of the solar cell 1 may be moved from the first deposition area 810 to an assembling station. For example, the solar cell pieces may be transported by a gripper adapted for gripping and transporting the solar cell pieces jointly. The solar cell pieces of the solar cell 1 may be arranged in an overlapping arrangement, wherein adjacent solar cell pieces may be bonded to each other in an overlapping manner. Adjacent solar cell pieces may be bonded to each other by an adhesive that was deposited by the deposition station 800 as described above. The adhesive may be disposed in an overlapping region of the adjacent solar cell pieces.

Fig. 19 shows an overlapping arrangement 1900 formed from the solar cell pieces 10a, 10b, 10c, 10d and 10e of the solar cell 1. The overlapping arrangement is formed from the solar cell pieces of one solar cell 1, and is referred to herein as a single-cell overlapping arrangement. The adhesives 30a, 30b, 30c, 30d and 30e are provided on the solar cell pieces 10a, 10b, 10c, 10d and 10e, respectively. The adhesives 30b, 30c, 30d and 30e bond adjacent solar cell pieces of the overlapping arrangement 1900 to each other. Further aspects such as busbars are not shown in Fig. 19 for the sake of simplicity.

A method according to embodiments described herein may include connecting, particularly bonding, the first solar cell piece (e.g. solar cell piece 10a) and the second solar cell piece (e.g. solar cell piece 10b) to each other by a first adhesive or a second adhesive (e.g. adhesive 30b) in a manner such that a portion of the first solar cell piece overlaps with a portion of the second solar cell piece.

A plurality of solar cells may be processed in a manner similar to the processing of the solar cell 1 described above. Each solar cell may be cleaved as described herein. The solar cell pieces of each cell may be subjected to a deposition of one or more features, particularly adhesives, as described herein. The solar cell pieces of each solar cell may be connected to each other to form a single-cell overlapping arrangement of solar cell pieces of that solar cell as described herein, similar to the overlapping arrangement 1900 as shown in Fig. 19. In turn, the plurality of single-cell overlapping arrangements resulting from the plurality of solar cells may be connected to each other in an overlapping manner to form a larger overlapping arrangement, i.e. a shingled solar cell arrangement. A first overlapping arrangement resulting from a first solar cell may be connected to a second solar cell arrangement resulting from a second solar cell by an adhesive disposed on a solar cell piece of one of the two overlapping arrangements. For example, 10, 50, 100 or more single-cell overlapping arrangements (resulting from 10, 50, 100 or more solar cells) may be bonded to each other to form a solar cell arrangement which may be several meters in length.

The first solar cell piece and the second solar cell piece as described herein may be comprised in a first overlapping arrangement including a plurality of overlapping solar cell pieces. A method as described herein may further include forming a second overlapping arrangement including another plurality of overlapping solar cell pieces. The method may include connecting the first overlapping arrangement to the second overlapping arrangement by an adhesive in a manner such that a portion of the first overlapping arrangement overlaps with a portion of the second overlapping arrangement.

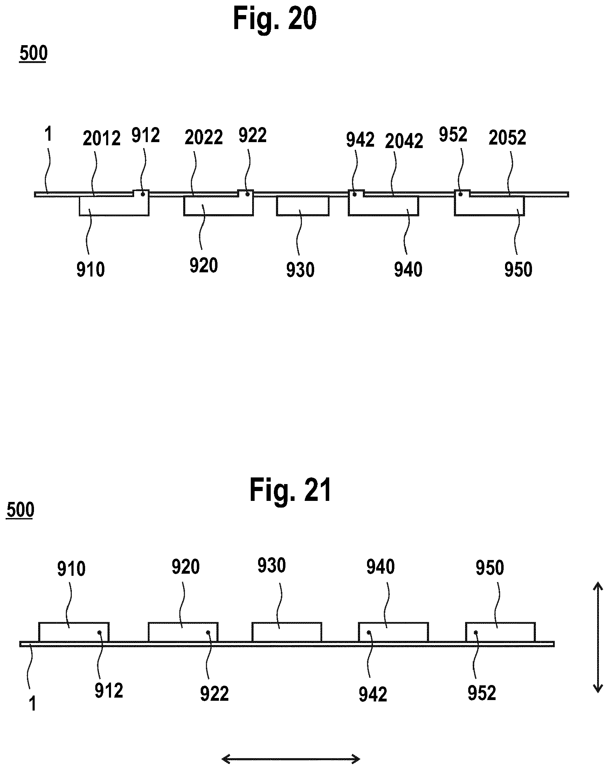

Fig. 20 shows a cleaving system 500 according to embodiments described herein. The holding members 910, 920, 940 and 950 may have respective rotation axes 912, 922, 942 and 952. A rotation axis may be a substantially horizontal axis. The rotation axes may lie in a common horizontal plane. The holding members 910, 920, 940 and 950 may have respective receiving surfaces 2012, 2022, 2042 and 2052 for receiving a solar cell or a solar cell piece. As shown in Fig. 20, a rotation axis of a holding member and a receiving surface of the holding member for receiving a solar cell or solar cell piece may lie substantially within a same plane. A distance between the rotation axis and the receiving surface in a direction perpendicular to the receiving surface may be substantially equal to zero, for example from 0 to 2 mm, particularly from 0 to 1 mm. A rotation axis of a holding member and a solar cell piece or solar cell received on the receiving surface of the holding member may lie substantially in a same plane. A distance between the rotation axis and the solar cell or solar cell piece supported on receiving surface in a direction perpendicular to the solar cell or solar cell piece is from 0 to 2 mm, particularly from 0 to 1 mm. The rotation axis may extend through the solar cell or solar cell piece supported by the holding member. An advantage of such an arrangement of the rotation axis is that the cleaving of the solar cell by a rotation of the holding member will not cause an undesired shift or other movement of the solar cell piece held by the holding member. The cleaving can be performed while maintaining the position of the solar cell piece on the holding member in a highly precise manner. In turn, this may ensure that the rejoining of the solar cell pieces held by the holding members is highly precise. It can be ensured that, after the rejoining movement(s), the solar cell pieces are arranged in their target positions in a highly accurate manner.

The cleaving system shown in Fig. 20 can include any of the features and perform any of the functions of the cleaving system shown in Figs. 5-18 and vice versa. The aspects and features described in relation to the cleaving system shown in Fig. 5-18 are also applicable to the cleaving system shown in Fig. 20 and vice versa.

Fig. 21 shows a further example of a cleaving system 500. The cleaving system 500 is provided in an upside-down configuration as compared to the cleaving systems shown in Figs. 5-18 and 20. The cleaving system 500 shown in Fig. 21 may include a plurality of holding members which may be configured for performing the same functions as the holding members of the cleaving systems described with respect to Figs. 5-18 and 20. In particular, one or more holding members may be adapted for performing a cleaving movement and/or a rejoining movement as described herein, with the difference that the cleaving system shown in Fig. 20 operates in an upside-down manner as compared to the cleaving system shown in the remaining figures. For example, the cleaving of a solar cell as performed by the cleaving system shown in Fig. 21 can be understood by considering the cleaving operations shown in Figs. 9 through 11 in an upside-down manner. For the sake of brevity, the operations in question will not be repeated here.

The cleaving system 500 shown in Fig. 21 may be movable in at least one of a vertical direction and a horizontal direction, as indicated by the arrows. The cleaving system may be configured for lifting the solar cell 1 from a surface (e.g. a surface of a conveyer belt). The cleaving system may be configured for transporting the solar cell over a horizontal distance. For example, the solar cell may be transported by the cleaving system from a loading position to the first deposition area 810. The solar cell may be positioned in the first deposition area 810 by the cleaving system. The cleaving system may be configured for performing a cleaving movement and/or a rejoining movement during transportation of the solar cell. In other words, the cleaving system shown in Fig. 21 may be understood as a system having the functionality of a cleaving system combined with the functionality of a gripper, so that cleaving and/or rejoining can be performed on-the-fly.

The cleaving system shown in Fig. 21 can include any of the features and perform any of the functions of the cleaving systems shown in Figs. 5-18 and 20 and vice versa. The aspects and features described in relation to the cleaving systems shown in Figs. 5-18 and 20 are also applicable to the cleaving system shown in Fig. 21 and vice versa.

Before cleaving, a solar cell 1 may include one or more scribed portions as described herein. Before cleaving, a solar cell 1 may be supported by one or more holding members of the cleaving system in a manner such that one or more scribed portions of the solar cell (e.g. scribed lines) face one or more respective rotation axes of the holding members of the cleaving system. A scribed portion of the solar cell may face, i.e. be directly in front of, a rotation axis of a holding member. The scribed portion, e.g. a scribed line, may be aligned with the rotation axis of the holding member. A horizontal offset between the scribed portion, e.g. scribed line, and the rotation axis may be substantially zero. A rejoining of the solar cell pieces performed after cleaving can be facilitated. By having the scribed lines in alignment with the rotation axes, the cleaving of the solar cell does not lead to undesired shift or displacement of the solar cell pieces held by the holding members. An accurate rejoining of the solar cell pieces can be provided.

The plurality of solar cell pieces of the solar cell 1, as described herein, may include the first solar cell piece (e.g. the solar cell piece 10a), the second solar cell piece (e.g. the solar cell piece 10b) and a third solar cell piece. The third solar cell piece may be understood, for example, as solar cell piece 10c shown in the figures. A method as described herein may include depositing one or more first features on the first solar cell piece, depositing one or more second features on the second solar cell piece and depositing, e.g. printing, one or more third features on the third solar cell piece while the first solar cell piece, the second solar cell piece and the third solar cell piece are jointly disposed in a same deposition area. The one or more first features, the one or more second features and the one or more third features may be deposited in parallel on the first solar cell piece, the second solar cell piece and the third solar cell piece, respectively. The one or more third features may include a third adhesive. The plurality of holding members of the cleaving system may include the first holding member, the second holding member and a third holding member. The third holding member can be understood, for example, as the holding member 530, the holding member 930 or the holding member 940 shown in the figures. It shall be understood that this is just an example for the sake of concreteness and the disclosure is not limited to this correspondence. The method may include performing a first movement of the third holding member to cleave the solar cell. The first movement of the third holding member may include a movement over an angle. The method may include arranging the third solar cell piece in a target position. The third solar cell piece may be arranged in the target position of the third solar cell piece by performing a second movement of the third holding member holding the third solar cell piece, the second movement of the third holding member being performed after the first movement of the third holding member. The first movement of the third holding member may include moving the third holding member over an angle to cleave the solar cell. The second movement of the third holding member may include moving the third holding member over an angle in a sense opposite to the first movement of the third holding member to position the third solar cell piece in a target position of the third solar cell piece. The second movement of the third holding member may be performed under the control of a controller as described herein. The method may include connecting the second solar cell piece and the third solar cell piece to each other, e.g. using an assembling station as described herein, in a manner such that a portion of the second solar cell piece overlaps with a portion of the third solar cell piece.

The cleaving system as described herein may include the first holding member (e.g. holding member 910), the second holding member (e.g. holding ember 920), a third holding member (e.g. holding member 930), a fourth holding member (e.g. holding member 940) and a fifth holding member (e.g. holding member 950). A method as described herein may include performing a first movement (or cleaving movement) of the first holding member and the fifth holding member before performing a first movement of the second holding member and the fourth holding member, as shown for example in Figs. 10-11. The method may include performing a second movement (or rejoining movement) of the second holding member and the fourth holding member before performing a second movement of the first holding member and the fifth holding member, as shown for example in Figs. 12-13.

According to a further embodiment, a method for processing a solar cell is provided. The method includes the following operations, which may be performed in the order provided. A solar cell is held by a plurality of holding members of a cleaving system. The plurality of holding members include one or more holding members each having a respective rotation axis. The rotation axis of each of the one or more holding members is disposed in a substantially same plane as the solar cell held by the plurality of holding members. A first rotation movement of the one or more holding members about the respective rotation axes is performed to separate the solar cell into a plurality of solar cell pieces. A second rotation movement of the one or more holding members in a sense opposite to the first rotation movement is performed to position one or more solar cell pieces held by the one or more holding members in a target position. After a further alignement step, The plurality of solar cell pieces are jointly transferred to a first deposition area. An adhesive is deposited on each solar cell piece of the plurality of solar cell pieces while the plurality of solar cell pieces are disposed in a first deposition area.

According to a further embodiment, an apparatus for processing solar cells is provided, as defined in claim 6. The apparatus includes a cleaving system including a plurality of holding members for separating a solar cell into a plurality of solar cell pieces including a first solar cell piece and a second solar cell piece. The plurality of holding members include a first holding member and a second holding member. The first holding member is rotatable about a first rotation axis. The first holding member has a first receiving surface to receive a portion of the solar cell. The first rotation axis and the first receiving surface are disposed in a substantially same plane. The apparatus includes a deposition station downstream of the cleaving system having a first deposition area. The deposition station is configured to deposit one or more first features on the first solar cell piece and one or more second features on the second solar cell piece while the first solar cell piece and the second solar cell piece are disposed in the first deposition area.

The deposition station may include a support providing the first deposition area. The first deposition area may be an area of the support. The deposition station may include a first deposition head for depositing the one or more first features and the one or more second features. The first deposition head may be a first printing head. The first deposition head may face the first deposition area. The first deposition head may simultaneously face both the first solar cell piece and the second solar cell piece disposed in the first deposition area.

A cleaving system as described herein may include a plurality of holding members including a first holding member and a second holding member. The first holding member may be configured to perform a first movement relative to the second holding member to cleave the solar cell. The first holding member may be configured to perform a second movement relative to the second holding member to position the first solar cell piece held by the first holding member in a target position. The first movement may be a movement of the first holding member over an angle. The second movement may be a movement of the first holding member over an angle in a sense opposite to the first movement.

The first holding member may be rotatable about a first rotation axis. The first holding member may have a first receiving surface to receive a portion of a solar cell. The first rotation axis and the first receiving surface may be disposed in a substantially same plane. A first distance between the first rotation axis and the first receiving surface may be from 0 to 2 mm, particularly from 0 to 1 mm. The first distance may be a distance in a direction perpendicular to the first receiving surface. The second holding member may be rotatable about a second rotation axis. The second holding member may have a second receiving surface to receive a portion of a solar cell. The second rotation axis and the second receiving surface may be disposed in a substantially same plane. A second distance between the second rotation axis and the second receiving surface may be from 0 to 2 mm, particularly from 0 to 1 mm. The second distance may be a distance in a direction perpendicular to the second receiving surface. The third holding member may be rotatable about a third rotation axis. The third holding member may have a third receiving surface to receive a portion of a solar cell. The third rotation axis and the third receiving surface may be disposed in a substantially same plane. A third distance between the third rotation axis and the third receiving surface may be from 0 to 2 mm, particularly from 0 to 1 mm. The third distance may be a distance in a direction perpendicular to the third receiving surface. The apparatus according to embodiments described herein may include a controller connected to the cleaving system.

The controller may be configured to control the second movement of the first holding member.

The first holding member may be movable, for example by one or more alignment actuators, to perform an alignment movement to align the first solar cell piece. The controller may be configured to control the alignment movement of the first holding member. The second holding member may be movable, for example by the one or more alignment actuators, to perform an alignment movement to align the second solar cell piece. The controller may be configured to control the alignment movement of the first holding member. The third holding member may be movable, for example by the one or more alignment actuators, to perform an alignment movement to align the third solar cell piece. The controller may be configured to control the alignment movement of the third holding member.

The deposition station as described herein may be a printer, particularly a screen printer. The deposition station may be an adhesive application station.

The cleaving system may include one or more gas stream sources arranged to provide a gas stream, for example an air stream, between adjacent holding members of the cleaving system. The cleaving system may include a first gas stream source arranged to provide a gas stream in a region between the first holding member and the second holding member. Debris particles at the solar cell pieces can be removed by the gas stream. The rejoining of the solar cell pieces can be facilitated.

The apparatus according to embodiments described herein may be configured, after the second movement, to jointly transfer the first solar cell piece and the second solar cell piece from a cleaving position to the first deposition area. A relative position of the first solar cell piece and the second solar cell piece may be maintained during the transferring. The transferring may be performed by a gripper adapted for jointly gripping the first solar cell piece and the second solar cell piece. Alternatively, the transferring may be performed by the cleaving system, wherein cleaving system may be movable over a horizontal distance.

The apparatus according to embodiments described herein may include an assembling station for connecting, particularly bonding, the first solar cell piece and the second solar cell piece to each other by the first adhesive in a manner such that a portion of the first solar cell piece overlaps with a portion of the second solar cell piece. The assembling station may be configured for forming a first overlapping arrangement as described herein. The assembling station may be configured for forming a second overlapping arrangement as described herein. The assembling station may be configured for connecting the first overlapping arrangement to the second overlapping arrangement as described herein.

An apparatus according to embodiments described herein may be configured to perform a method according to any of the embodiments described herein.

According to a further embodiment, a cleaving system for cleaving a solar cell is provided. The cleaving system includes a plurality of holding members including a first holding member, a second holding member and a third holding member. The first holding member has a first receiving surface for receiving a first portion of the solar cell. The second holding member has a second receiving surface for receiving a second portion of the solar cell. The third holding member has a third receiving surface for receiving a third portion of the solar cell. The first holding member and the third holding member are each rotatable about a respective rotation axis. The rotation axis of the first holding member is disposed in a substantially same plane as the first receiving surface. The rotation axis of the third holding member is disposed in a substantially same plane as the third receiving surface. The cleaving system may include any of the aspects and features described in relation to the cleaving systems described herein.

According to a further embodiment, a method for processing a solar cell is provided. The method includes holding a solar cell by a plurality of holding members of a cleaving system. The plurality of holding members include a first holding member and a second holding member. The method includes performing at least a first movement of the first holding member relative to the second holding member to separate the solar cell into a plurality of solar cell pieces including a first solar cell piece and a second solar cell piece. The method includes performing at least a second movement of the first holding member holding the first solar cell piece to arrange the first solar cell piece in a target position. The second movement is performed after the first movement. The method includes performing an alignment movement of the first holding member holding the first solar cell piece to align the first solar cell piece. The method includes depositing one or more first features on the first solar cell piece and depositing one or more second features on the second solar cell piece while the first solar cell piece and the second solar cell piece are disposed in a same deposition area.

According to a further embodiment, a method for processing a solar cell is provided. The method includes performing a first rotation movement of one or more holding members of a cleaving system to separate a solar cell into a plurality of solar cell pieces. The method includes performing a second rotation movement of the one or more holding members in a sense opposite to the first rotation movement to position one or more solar cell pieces held by the one or more holding members in a target position. The method includes performing an alignment movement of at least one of the one or more holding members to align at least one of the one or more solar cell pieces. The method includes jointly transferring the plurality of solar cell pieces to a first deposition area. The method includes depositing an adhesive on each solar cell piece of the plurality of solar cell pieces while the plurality of solar cell pieces are disposed in a first deposition area.

According to a further embodiment, an apparatus for processing solar cells is provided. The apparatus includes a cleaving system for separating a solar cell into a plurality of solar cell pieces including a first solar cell piece and a second solar cell piece. The cleaving system includes a plurality of holding members including a first holding member and a second holding member. The first holding member is movable relative to the second holding member according to a first movement to cleave the solar cell. The first holding member is movable relative to the second holding member according to a second movement to position the first solar cell piece held by the first holding member in a target position. The first holding member is movable according to an alignment movement to perform an alignment of the first solar cell piece. The apparatus may include a controller connected to the cleaving system to control the alignment movement of the first holding member. The apparatus includes a deposition station downstream of the cleaving system having a first deposition area. The deposition station is configured to deposit one or more first features on the first solar cell piece and one or more second features on the second solar cell piece while the first solar cell piece and the second solar cell piece are disposed in the first deposition area.

## Claims

1. A method for processing a solar cell (1), comprising:
holding the solar cell by a plurality of holding members of a cleaving system (500), the plurality of holding members including a first holding member (510, 910) and a second holding member (520, 920), the first holding member being rotatable about a first rotation axis (912);
performing at least a first rotation movement of the first holding member about the first rotation axis to separate the solar cell into a plurality of solar cell pieces including a first solar cell piece (10a) and a second solar cell piece (10b);
performing at least a second rotation movement of the first holding member in a sense opposite to the first rotation movement to arrange the first solar cell piece in a target position; and
depositing one or more first features (30a) on the first solar cell piece and one or more second features (30b) on the second solar cell piece while the first solar cell piece and the second solar cell piece are disposed in a same deposition area (810),
**characterized in that**:
the first rotation axis and the solar cell held by the plurality of holding members are disposed in a substantially same plane, wherein a first distance between the first rotation axis and the solar cell held by the plurality of holding members is from 0 to 2 mm, the first distance being a distance in a direction perpendicular to the solar cell,
and **in that** the method further comprises:
performing an alignment movement of the first holding member holding the first solar cell piece to align the first solar cell piece, wherein the first solar cell piece is aligned with respect to an adjacent solar cell piece held by an adjacent holding member and/or with respect to one or more alignment marks, wherein the alignment movement is performed after the second rotation movement, wherein the first holding member is movable by one or more alignment actuators to perform the alignment movement to align the first solar cell piece,
wherein the alignment movement of the first holding member is performed under the control of a controller connected to the cleaving system; and
jointly transporting the solar cell pieces of the solar cell from the cleaving system to the deposition area by a gripper adapted for gripping and moving multiple solar cell pieces together.

2. The method of claim 1, wherein the first solar cell piece and the second solar cell piece are adjacent solar cell pieces of the plurality of solar cell pieces, the method further comprising:
providing a gas stream in a region between the first solar cell piece and the second solar cell piece before performing the second rotation movement.

3. The method of any of the preceding claims, wherein the one or more first features and the one or more second features are deposited in parallel on the first solar cell piece and the second solar cell piece.

4. The method of any of the preceding claims, wherein the one or more first features include a first adhesive and the one or more second features include a second adhesive,
particularly wherein the method further comprises:
connecting the first solar cell piece and the second solar cell piece to each other by the first adhesive or the second adhesive in a manner such that a portion of the first solar cell piece overlaps with a portion of the second solar cell piece.

5. The method of any of the preceding claims, wherein depositing the one or more first features and the one or more second features includes printing, particularly screen printing, the one or more first features and the one or more second features.

6. An apparatus for processing solar cells, comprising:
a cleaving system (500) including a plurality of holding members for separating a solar cell (1) into a plurality of solar cell pieces including a first solar cell piece (10a) and a second solar cell piece (10b), the plurality of holding members including a first holding member (510, 910) and a second holding member (520, 920), the first holding member being rotatable about a first rotation axis (912) and having a first receiving surface to receive a portion of the solar cell,
wherein the first holding member is rotatable about the first rotation axis according to a first rotation movement to cleave the solar cell and rotatable about the first rotation axis according to a second rotation movement to position the first solar cell piece held by the first holding member in a target position; and
a deposition station downstream of the cleaving system having a first deposition area (810), the deposition station being configured to deposit one or more first features (30a) on the first solar cell piece and one or more second features (30b) on the second solar cell piece while the first solar cell piece and the second solar cell piece are disposed in the first deposition area,
**characterized in that**:
the first rotation axis and the first receiving surface are disposed in a substantially same plane, wherein a first distance between the first rotation axis and the first receiving surface is from 0 to 2 mm, the first distance being a distance in a direction perpendicular to the first receiving surface;
the first holding member is movable by one or more alignment actuators to perform an alignment movement to align the first solar cell piece, wherein the first solar cell piece is aligned with respect to an adjacent solar cell piece held by an adjacent holding member and/or with respect to one or more alignment marks, the apparatus further comprising a controller connected to the cleaving system to control the alignment movement of the first holding member in a manner such that the alignment movement is performed after the second rotation movement; and
wherein the apparatus is configured for jointly transporting the solar cell pieces of the solar cell from the cleaving system to the first deposition area by a gripper adapted for gripping and moving multiple solar cell pieces together.

7. The apparatus of claim 6, wherein the cleaving system further includes:
a first gas stream source arranged to provide a gas stream in a region between the first holding member and the second holding member.

## Patentansprüche

1. Verfahren zur Bearbeitung einer Solarzelle (1), umfassend:
Halten der Solarzelle durch eine Vielzahl von Halteelementen eines Spaltungssystems (500), wobei die Vielzahl von Halteelementen ein erstes Halteelement (510, 910) und ein zweites Halteelement (520, 920) umfasst, wobei das erste Halteelement um eine erste Drehachse (912) drehbar ist;
Durchführen mindestens einer ersten Drehbewegung des ersten Halteelements um die erste Drehachse, um die Solarzelle in eine Vielzahl von Solarzellenstücken zu trennen, einschließlich eines ersten Solarzellenstücks (10a) und eines zweiten Solarzellenstücks (10b);
Durchführen mindestens einer zweiten Drehbewegung des ersten Halteelements in einer der ersten Drehbewegung entgegengesetzten Richtung, um das erste Solarzellenstück in einer Zielposition anzuordnen; und
Abscheiden eines oder mehrerer erster Merkmale (30a) auf dem ersten Solarzellenstück und eines oder mehrerer zweiter Merkmale (30b) auf dem zweiten Solarzellenstück, während das erste Solarzellenstück und das zweite Solarzellenstück in einem gleichen Abscheidungsbereich (810) angeordnet sind,
**dadurch gekennzeichnet, dass**:
die erste Drehachse und die Solarzelle, die von der Vielzahl von Halteelementen gehalten wird, in einer im Wesentlichen gleichen Ebene angeordnet sind, wobei ein erster Abstand zwischen der ersten Drehsachse und der Solarzelle, die von der Vielzahl von Halteelementen gehalten wird, 0 bis 2 mm beträgt, wobei der erste Abstand ein Abstand in einer Richtung senkrecht zu der Solarzelle ist,
und dass das Verfahren ferner umfasst:
Durchführen einer Ausrichtungsbewegung des ersten Halteelements, das das erste Solarzellenstück hält, um das erste Solarzellenstück auszurichten, wobei das erste Solarzellenstück in Bezug auf ein benachbartes Solarzellenstück, das von einem benachbarten Halteelement gehalten wird, und/oder in Bezug auf eine oder mehrere Ausrichtungsmarken ausgerichtet wird, wobei die Ausrichtungsbewegung nach der zweiten Drehbewegung durchgeführt wird, wobei das erste Halteelement durch einen oder mehrere Ausrichtungsaktuatoren bewegt werden kann, um die Ausrichtungsbewegung zum Ausrichten des ersten Solarzellenstücks durchzuführen,
wobei die Ausrichtungsbewegung des ersten Halteelements unter der Kontrolle einer mit dem Spaltungssystem verbundenen Steuerung durchgeführt wird; und
gemeinsames Transportieren der Solarzellenstücke der Solarzelle von dem Spaltungssystem zu dem Abscheidungsbereich durch einen Greifer, der zum gemeinsamen Greifen und Bewegen mehrerer Solarzellenstücke geeignet ist.

2. Verfahren nach Anspruch 1, wobei das erste Solarzellenstück und das zweite Solarzellenstück benachbarte Solarzellenstücke der Vielzahl von Solarzellenstücken sind, wobei das Verfahren ferner umfasst:
Bereitstellen eines Gasstroms in einem Bereich zwischen dem ersten Solarzellenstück und dem zweiten Solarzellenstück vor der Durchführung der zweiten Drehbewegung.

3. Verfahren nach einem der vorhergehenden Ansprüche, wobei das eine oder die mehreren ersten Merkmale und das eine oder die mehreren zweiten Merkmale parallel auf dem ersten Solarzellenstück und dem zweiten Solarzellenstück abgeschieden werden.

4. Verfahren nach einem der vorhergehenden Ansprüche, wobei das eine oder die mehreren ersten Merkmale einen ersten Klebstoff und das eine oder die mehreren zweiten Merkmale einen zweiten Klebstoff aufweisen,
insbesondere wobei das Verfahren ferner umfasst:
Verbinden des ersten Solarzellenteils und des zweiten Solarzellenteils miteinander durch den ersten Klebstoff oder den zweiten Klebstoff in einer Weise, dass sich ein Teil des ersten Solarzellenteils mit einem Teil des zweiten Solarzellenteils überlappt.

5. Verfahren nach einem der vorhergehenden Ansprüche, wobei das Abscheiden des einen oder der mehreren ersten Merkmale und des einen oder der mehreren zweiten Merkmale das Bedrucken, insbesondere das Siebdrucken, des einen oder der mehreren ersten Merkmale und des einen oder der mehreren zweiten Merkmale umfasst.

6. Vorrichtung zur Bearbeitung von Solarzellen, umfassend:
ein Spaltungssystem (500) mit einer Vielzahl von Halteelementen zum Trennen einer Solarzelle (1) in eine Vielzahl von Solarzellenstücken einschließlich eines ersten Solarzellenstücks (10a) und eines zweiten Solarzellenstücks (10b), wobei die Vielzahl von Halteelementen ein erstes Halteelement (510, 910) und ein zweites Halteelement (520, 920) umfasst, wobei das erste Halteelement um eine erste Drehachse (912) drehbar ist und eine erste Aufnahmefläche zur Aufnahme eines Teils der Solarzelle aufweist,
wobei das erste Halteelement um die erste Drehachse gemäß einer ersten Drehbewegung drehbar ist, um die Solarzelle zu spalten, und um die erste Drehachse gemäß einer zweiten Drehbewegung drehbar ist, um das von dem ersten Halteelement gehaltene erste Solarzellenstück in einer Zielposition zu positionieren; und
eine Abscheidungsstation stromabwärts des Spaltungssystems mit einem ersten Abscheidungsbereich (810), wobei die Abscheidungsstation konfiguriert ist, um ein oder mehrere erste Merkmale (30a) auf dem ersten Solarzellenstück und ein oder mehrere zweite Merkmale (30b) auf dem zweiten Solarzellenstück abzuscheiden, während das erste Solarzellenstück und das zweite Solarzellenstück in dem ersten Abscheidungsbereich angeordnet sind,
**dadurch gekennzeichnet, dass**:
die erste Drehachse und die erste Aufnahmefläche in einer im Wesentlichen gleichen Ebene angeordnet sind, wobei ein erster Abstand zwischen der ersten Drehachse und der ersten Aufnahmefläche 0 bis 2 mm beträgt, wobei der erste Abstand ein Abstand in einer Richtung senkrecht zu der ersten Aufnahmefläche ist;
das erste Halteelement durch einen oder mehrere Ausrichtungsaktuatoren bewegbar ist, um eine Ausrichtungsbewegung durchzuführen, um das erste Solarzellenstück auszurichten, wobei das erste Solarzellenstück in Bezug auf ein benachbartes Solarzellenstück, das durch ein benachbartes Halteelement gehalten wird, und/oder in Bezug auf eine oder mehrere Ausrichtungsmarkierungen ausgerichtet wird, wobei die Vorrichtung ferner eine Steuerung umfasst, die mit dem Spaltungssystem verbunden ist, um die Ausrichtungsbewegung des ersten Halteelements in einer Weise zu steuern, dass die Ausrichtungsbewegung nach der zweiten Drehbewegung durchgeführt wird; und
wobei die Vorrichtung so konfiguriert ist, dass die Solarzellenstücke der Solarzelle gemeinsam von dem Spaltungssystem zu dem ersten Abscheidungsbereich durch einen Greifer transportiert werden, der dafür ausgelegt ist, mehrere Solarzellenstücke gemeinsam zu greifen und zu bewegen.

7. Vorrichtung nach Anspruch 6, wobei das Spaltungssystem ferner umfasst:
eine erste Gasstromquelle, die so angeordnet ist, dass sie einen Gasstrom in einem Bereich zwischen dem ersten Halteelement und dem zweiten Halteelement bereitstellt.

## Revendications

1. Procédé destiné à traiter une cellule solaire (1), comprenant :
le maintien de la cellule solaire par une pluralité d'éléments de maintien d'un système de clivage (500), la pluralité d'éléments de maintien comportant un premier élément de maintien (510, 910) et un second élément de maintien (520, 920), le premier élément de maintien étant rotatif autour d'un premier axe de rotation (912) ;
le fait d'effectuer au moins un premier mouvement de rotation du premier élément de maintien autour du premier axe de rotation pour séparer la cellule solaire en plusieurs morceaux de cellule solaire comportant un premier morceau de cellule solaire (10a) et un second morceau de cellule solaire (10b) ;
le fait d'effectuer au moins un second mouvement de rotation du premier élément de maintien dans un sens opposé au premier mouvement de rotation pour agencer le premier morceau de cellule solaire dans une position cible ; et
le dépôt d'une ou plusieurs premières caractéristiques (30a) sur le premier morceau de cellule solaire et d'une ou plusieurs secondes caractéristiques (30b) sur le second morceau de cellule solaire alors que le premier morceau de cellule solaire et le second morceau de cellule solaire sont disposés dans une même zone de dépôt (810),
**caractérisé en ce que** :
le premier axe de rotation et la cellule solaire maintenue par la pluralité d'éléments de maintien sont disposés dans un plan sensiblement identique, une première distance entre le premier axe de rotation et la cellule solaire maintenue par la pluralité d'éléments de maintien étant comprise entre 0 et 2 mm, la première distance étant une distance dans une direction perpendiculaire à la cellule solaire,
**et en ce que** le procédé comprend en outre :
le fait d'effectuer un mouvement d'alignement du premier élément de maintien tenant la première pièce de cellule solaire pour aligner la première pièce de cellule solaire, la première pièce de cellule solaire étant alignée par rapport à une pièce de cellule solaire adjacente tenue par un élément de maintien adjacent et/ou par rapport à une ou plusieurs marques d'alignement, dans lequel le mouvement d'alignement est effectué après le second mouvement de rotation, dans lequel le premier élément de maintien est déplacé par un ou plusieurs actionneurs d'alignement pour effectuer le mouvement d'alignement afin d'aligner la première pièce de cellule solaire,
dans lequel le mouvement d'alignement du premier élément de maintien est effectué sous la commande d'un dispositif de commande connecté au système de clivage ; et
le transport de manière conjointe des morceaux de la cellule solaire du système de clivage à la zone de dépôt à l'aide d'une pince adaptée à la préhension et au déplacement de plusieurs morceaux de cellule solaire ensemble.

2. Procédé selon la revendication 1, dans lequel la première pièce de cellule solaire et la seconde pièce de cellule solaire sont des pièces de cellule solaire adjacentes de la pluralité de pièces de cellule solaire, le procédé comprenant en outre :
la fourniture d'un flux de gaz dans une région située entre la première pièce de cellule solaire et la seconde pièce de cellule solaire avant d'effectuer le second mouvement de rotation.

3. Procédé selon l'une quelconque des revendications précédentes, dans lequel une ou plusieurs premières caractéristiques et une ou plusieurs secondes caractéristiques sont déposées en parallèle sur la première pièce de cellule solaire et la seconde pièce de cellule solaire.

4. Procédé selon l'une quelconque des revendications précédentes, dans lequel la ou les premières caractéristiques comportent un premier adhésif et la ou les secondes caractéristiques comportent un second adhésif,
particulièrement dans lequel le procédé comprend en outre :
la liaison de la première pièce de cellule solaire et la seconde pièce de cellule solaire l'une à l'autre par le premier adhésif ou le second adhésif de manière à ce qu'une partie de la première pièce de cellule solaire chevauche une partie de la seconde pièce de cellule solaire.

5. Procédé selon l'une quelconque des revendications précédentes, dans lequel le dépôt de la ou des premières caractéristiques et de la ou des secondes caractéristiques comporte l'impression, en particulier la sérigraphie, de la ou des premières caractéristiques et de la ou des secondes caractéristiques.

6. Appareil pour le traitement de cellules solaires, comprenant :
un système de clivage (500) comportant une pluralité d'éléments de maintien pour séparer une cellule solaire (1) en une pluralité de morceaux de cellule solaire comportant un premier morceau de cellule solaire (10a) et un second morceau de cellule solaire (10b), la pluralité d'éléments de maintien comportant un premier élément de maintien (510, 910) et un second élément de maintien (520, 920), le premier élément de maintien étant rotatif autour d'un premier axe de rotation (912) et ayant une première surface de réception pour recevoir une partie de la cellule solaire,
dans lequel le premier élément de maintien peut tourner autour du premier axe de rotation selon un premier mouvement de rotation pour couper la cellule solaire et peut tourner autour du premier axe de rotation selon un second mouvement de rotation pour positionner le premier morceau de cellule solaire maintenu par le premier élément de maintien dans une position cible ; et
une station de dépôt en aval du système de clivage ayant une première zone de dépôt (810), la station de dépôt étant configurée pour déposer une ou plusieurs premières caractéristiques (30a) sur la première pièce de cellule solaire et une ou plusieurs secondes caractéristiques (30b) sur la seconde pièce de cellule solaire alors que la première pièce de cellule solaire et la seconde pièce de cellule solaire sont disposées dans la première zone de dépôt,
**caractérisé en ce que** :
le premier axe de rotation et la première surface de réception sont disposés dans un plan sensiblement identique, dans lequel une première distance entre le premier axe de rotation et la première surface de réception est comprise entre 0 et 2 mm, la première distance étant une distance dans une direction perpendiculaire à la première surface de réception ;
le premier élément de maintien est déplacé par un ou plusieurs actionneurs d'alignement pour effectuer un mouvement d'alignement afin d'aligner le premier morceau de cellule solaire, dans lequel le premier morceau de cellule solaire est aligné par rapport à un morceau de cellule solaire adjacent tenu par un élément de maintien adjacent et/ou par rapport à une ou plusieurs marques d'alignement, l'appareil comprenant en outre un dispositif de commande connecté au système de clivage pour commander le mouvement d'alignement du premier élément de maintien de manière à ce que le mouvement d'alignement soit effectué après le second mouvement de rotation ; et
dans lequel l'appareil est configuré pour transporter de manière conjointe les morceaux de la cellule solaire du système de clivage à la première zone de dépôt à l'aide d'une pince adaptée à la saisie et au déplacement de plusieurs morceaux de cellule solaire ensemble.

7. Appareil selon la revendication 6, dans lequel le système de clivage comporte en outre :
une première source de flux gazeux agencée pour fournir un flux gazeux dans une zone située entre le premier et le second élément de maintien.
